# EUROPEAN PATENT APPLICATION

(11) **EP 4 709 133 A1**
(43) Date of publication of application: **11.03.2026**
(21) Application number: 25197019.0
(22) Date of filing: 20.08.2025
(51) Int. Cl.: H10W 40/25, H10W 90/00, H10W 70/60, H10W 70/40

(54) **DUAL-SIDE COOLING POWER MODULES AND MANUFACTURING METHODS THEREOF, AND ELECTRICAL SYSTEMS**

(30) Priority: 30.08.2024 CN 202411218817; 14.08.2025 US 202519300514
(71) Applicant: Shenzhen STS Microelectronics Co., Ltd., Shenzhen 518048 (CN)
(72) Inventor: ZHENG, Nan Nan, Shenzhen, 518038 (CN); CHEN, Qiao, Shenzhen, 518040 (CN); LIANG, Lin, Shenzhen, 518048 (CN)
(74) Representative: Cabinet Beaumont

(57) **Abstract**

The present disclosure relates to dual-side cooling power modules, manufacturing methods thereof, and electrical systems. There is provided a dual-side cooling power module, comprising: a first multilayer substrate, comprising: a first insulating material layer, a first metal layer, and a second metal layer, the second metal layer comprising a plurality of first step structures having a first height; a second multilayer substrate, comprising: a second insulating material layer, a third metal layer, and a fourth metal layer, the fourth metal layer comprising a plurality of second step structures having a second height.

## Description

### BACKGROUND

### Technical Field

The present disclosure mainly relates to the field of semiconductor, and more specifically, dual-side cooling power modules, manufacturing methods thereof, and electrical systems.

### Description of the Related Art

A conventional dual-side cooling (DSC) power module achieves dual-side cooling by disposing a chip between two copper-coated ceramic substrates. In order to support the substrates on both sides and achieve the electric connection and other purposes, spacers and pillars need to be disposed between the two substrates in addition to the chip. A spacer is usually disposed between the chip and the substrate on one side, and a pillar is directly disposed between the two substrates. However, the presence of the spacers and the pillars may bring many negative effects, such as increasing the area and thickness of the power module and causing poor heat dissipation effect of the chip, thereby hindering the process of further miniaturizing the power module and further improving performance.

Therefore, there is a need in the prior art for an improved dual-side cooling power module and manufacturing method thereof.

### Brief Summary

The present disclosure is directed to provide improved dual-side cooling power modules and manufacturing methods thereof, and improved electrical systems.

An embodiment provides a dual-side cooling power module, comprising:
a first multilayer structure, comprising:
   a first insulating material layer,
   a first metal layer on one surface of the first insulating material layer, and
   a second metal layer on the first insulating material layer, the second metal layer comprising a plurality of first step structures having a first height;
a second multilayer structure, comprising:
   a second insulating material layer,
   a third metal layer on the second insulating material layer, and
   a fourth metal layer on the second insulating material layer, the fourth metal layer comprising a plurality of second step structures having a second height; and
      one or more chips,
      wherein each chip is coupled and supported between a corresponding first step structure and a corresponding second step structure.

According to an embodiment:
said first metal layer is coupled to the first insulating material layer;
said second metal layer is on the opposite other surface of the first insulating material layer and coupled to the first insulating material layer;
said third metal layer is on one surface of the second insulating material layer and coupled to the second insulating material layer;
said fourth metal layer is on the opposite other surface of the second insulating material layer and coupled to the second insulating material layer.

An embodiment provides a method, comprising:
forming a dual-side cooling power module, by:
   coupling each of one or more chips to a first multilayer structure and a second multilayer structure, the first multilayer structure includes a first insulating material layer, a first metal layer on the first insulating material layer, and a second metal layer on the first insulating material layer, the second metal layer comprising a plurality of first step structures having a first height, the second multilayer structure includes a second insulating material layer, a third metal layer on the second insulating material layer, and a fourth metal layer on the second insulating material layer, the fourth metal layer comprising a plurality of second step structures having a second height, the coupling including coupling each chip to one of the second metal layer of the first multilayer structure and the fourth metal layer of the second multilayer structure, respectively; and
   coupling the first multilayer structure and the second multilayer structure to have the second metal layer and the fourth metal layer face each other,
wherein each chip is coupled and supported between a corresponding first step structure and a corresponding second step structure.

According to an embodiment of the module or method, each chip is disposed between the first multilayer structure and the second multilayer structure and further coupled to the other of the second metal layer and the fourth metal layer.

According to an embodiment of the module or method, the one or more chips comprise:
a first chip coupled to the second metal layer with a front surface and coupled to the fourth metal layer with a back surface; and
a second chip coupled to the fourth metal layer with a front surface and coupled to the second metal layer with a back surface.

According to an embodiment of the module or method:
the one or more chips comprise a plurality of first chips and a plurality of second chips, wherein the number of the plurality of first chips is the same as the number of the plurality of second chips;
the plurality of first chips are in a centrally symmetric distribution in a plane parallel to the first multilayer structure and the second multilayer structure with respect to a center of the first multilayer structure or the second multilayer structure; and
the plurality of second chips are in a centrally symmetric distribution in a plane parallel to the first multilayer structure and the second multilayer structure with respect to the center of the first multilayer structure or the second multilayer structure.

An embodiment provides an electrical system, comprising a dual-side cooling power module as disclosed.

According to an embodiment of the module, method or system:
said second metal layer is spaced from the first metal layer by the first insulating material layer; and
said fourth metal layer is spaced from the third metal layer by the second insulating material layer;
a first plurality of chips of said one or more chips is coupled to the first multilayer structure and is facing the second multilayer structure, the first plurality of chips being coupled to the second metal layer;
a second plurality of chips of said one or more chips is coupled to the second multilayer structure and is facing the first multilayer structure, the second plurality of chips being coupled to the fourth metal layer, each chip of the first plurality of chips and the second plurality of chips being coupled and supported between a corresponding first step structure of the plurality of first step structures and a corresponding second step structure of the plurality of second step structures.

According to an embodiment of the module, method or system, each chip is electrically coupled with a corresponding first step structure and a corresponding second step structure

According to an embodiment of the module, method or system, the second metal layer and the fourth metal layer are shaped by a same half-etching process.

According to an embodiment, the module, method or system, further comprises:
one or more leads from a lead frame;
wherein the second metal layer further comprises one or more third step structures at periphery of the second metal layer and having the first height, the one or more third step structures configured to attach and support a corresponding lead; and
wherein the fourth metal layer further comprises one or more fourth step structures at periphery of the fourth metal layer and having the second height, the one or more fourth step structures configured to couple and support a corresponding lead.

According to an embodiment of the module, method or system, the one or more leads comprise at least one of:
a first lead coupled and supported between a corresponding third step structure and a corresponding fourth step structure;
a second lead coupled and supported between a corresponding third step structure and a planar edge portion of the fourth metal layer; and
a third lead coupled and supported between a planar edge portion of the second metal layer and a corresponding fourth step structure.

According to an embodiment of the module, method or system, at least one of the one or more third step structures, the one or more fourth step structures, the planar edge portion of the second metal layer, and the planar edge portion of the fourth metal layer has an island-shaped blind end structure.

According to an embodiment of the module, method or system:
at least one of the plurality of first step structures coupled to a chip is electrically coupled to a corresponding third step structure through a planar portion of the second metal layer, and electrically configured to couple the chip to a corresponding lead; and
at least one of the plurality of second step structures coupled to a chip is electrically coupled to a corresponding fourth step structure through a planar portion of the fourth metal layer, and electrically configured to couple the chip to a corresponding lead.

According to an embodiment of the module, method or system, the first height is the same as the second height.

According to an embodiment of the module, method or system, the first multilayer structure is a first multilayer substrate and the second multilayer structure is a second multilayer substrate.

According to one aspect of the present disclosure, there is provided a dual-side cooling power module, comprising: a first multilayer substrate, comprising: a first insulating material layer, a first metal layer on one surface of the first insulating material layer and attached to the first insulating material layer, and a second metal layer on the opposite other surface of the first insulating material layer and attached to the first insulating material layer, the second metal layer comprising a plurality of first step structures having a first height; a second multilayer substrate, comprising: a second insulating material layer, a third metal layer on one surface of the second insulating material layer and attached to the second insulating material layer, and a fourth metal layer on the opposite other surface of the second insulating material layer and attached to the second insulating material layer, the fourth metal layer comprising a plurality of second step structures having a second height; and one or more chips disposed between the first multilayer substrate and the second multilayer substrate and attached to the second metal layer and the fourth metal layer. Each chip is attached and supported between a corresponding first step structure and a corresponding second step structure and is electrically connected with them.

According to another aspect of the present disclosure, there is provided an electrical system, comprising the aforementioned dual-side cooling power module.

According to yet another aspect of the present disclosure, there is provided a manufacturing method of a dual-side cooling power module, comprising steps of: providing a first multilayer substrate, the first multilayer substrate comprising: a first insulating material layer, a first metal layer on one surface of the first insulating material layer and attached to the first insulating material layer, and a second metal layer on the opposite other surface of the first insulating material layer and attached to the first insulating material layer, the second metal layer comprising a plurality of first step structures having a first height; providing a second multilayer substrate, the second multilayer substrate comprising: a second insulating material layer, a third metal layer on one surface of the second insulating material layer and attached to the second insulating material layer, and a fourth metal layer on the opposite other surface of the second insulating material layer and attached to the second insulating material layer, the fourth metal layer comprising a plurality of second step structures having a second height; attaching each of one or more chips to one of the second metal layer of the first multilayer substrate and the fourth metal layer of the second multilayer substrate, respectively; and bonding the first multilayer substrate and the second multilayer substrate in such a way that the second metal layer and the fourth metal layer face each other, so that each chip is disposed between the first multilayer substrate and the second multilayer substrate and further attached to the other of the second metal layer and the fourth metal layer. Each chip is attached and supported between a corresponding first step structure and a corresponding second step structure and is electrically connected with them.

Other features and advantages of the present disclosure will become clearer from the following detailed description of illustrative embodiments of the present disclosure with reference to the accompanying drawings.

### Brief description of the several view of the drawings

The accompanying drawings, which form a part of the specification, illustrate embodiments of the present disclosure and together with the specification, serve to explain the principles of the present disclosure.

The present disclosure can be more clearly understood from the following detailed description with reference to the accompanying drawings, in which,
Fig. 1 schematically shows a cross-sectional view of a conventional dual-side cooling power module 10;
Fig. 2 schematically shows a cross-sectional view of a dual-side cooling power module according to an embodiment of the present disclosure;
Fig. 3 schematically shows a schematic diagram of chip distribution in the power module that includes more chips according to an embodiment of the present disclosure;
Figs. 4A and 4B schematically show cross-sectional views of a lead connection portion of a power module according to an embodiment of the present disclosure;
Fig. 5 shows an illustrative flow diagram of a manufacturing method of a dual-side cooling power module according to an embodiment of the present disclosure;
Fig. 6 schematically shows a cross-sectional view of an apparatus corresponding to a part of steps of the method shown in Fig. 5;
Fig. 7A shows a schematic three-dimensional modeling model of a dual-side cooling power module according to an embodiment of the present disclosure, Fig. 7B shows a top perspective view of a part of components in the power module of Fig. 7A, and Fig. 7C shows a bottom perspective view of a part of components in the power module of Fig. 7A.

Note that in the embodiments described below, the same reference numbers are sometimes shared between different drawings to denote the same portions or portions having the same functions, and a repetitive description thereof will be omitted. In some cases, similar items are denoted using similar reference numbers and letters, and thus, once a certain item is defined in a drawing, it does not need to be further discussed in subsequent drawings.

For ease of understanding, positions, sizes, ranges, and the like of the various structures shown in the drawings and the like sometimes do not indicate actual positions, sizes, ranges, and the like. Therefore, the present disclosure is not limited to the positions, sizes, ranges, and the like disclosed in the drawings.

### Detailed description

Embodiments of the present disclosure will be described in detail below with reference to the accompanying drawings. The following description of at least one exemplary embodiment is merely illustrative in fact and is in no way intended to limit the present disclosure and its applications or uses. That is to say, the structures and methods herein are shown in an exemplary manner to illustrate different embodiments of the structures and methods in the present disclosure. However, those skilled in the art will understand that they merely illustrate exemplary, not exhaustive, manners in which the present disclosure can be implemented.

In all the examples shown and discussed here, the relative arrangement, numerical expressions and numerical values of components and steps set forth in these embodiments do not limit the scope of the present disclosure unless otherwise specified. In all examples shown and discussed herein, any specific values should be interpreted as exemplary only and not as a limitation. Therefore, other examples of exemplary embodiments can have different values. Furthermore, the drawings are not necessarily drawn to scale, and some features may be exaggerated to show details of specific components.

The technology, method and device known to those skilled in the relevant fields may not be discussed in detail, but in appropriate cases, they should be regarded as part of the granted specification.

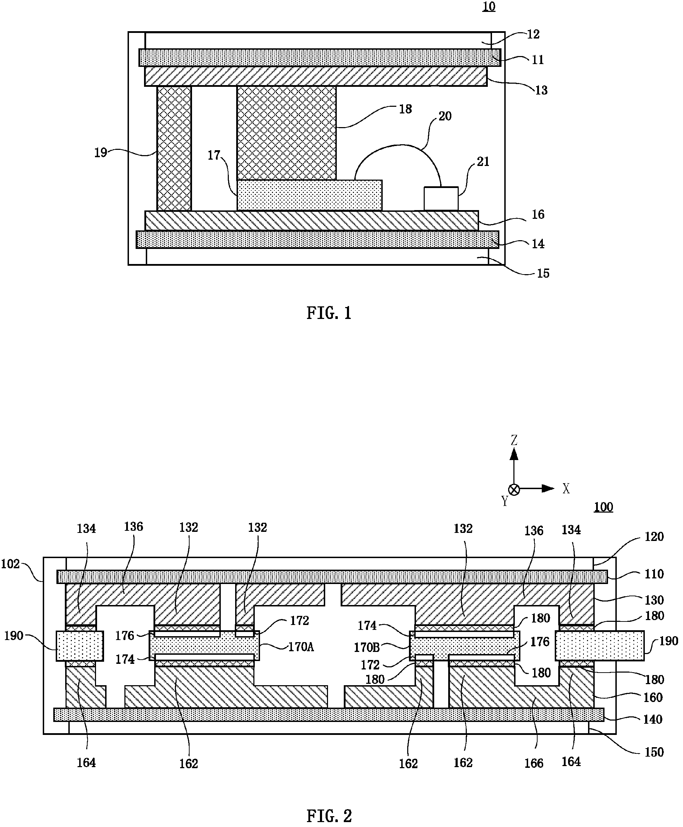

Fig. 1 schematically shows a cross-sectional view of a conventional dual-side cooling power module 10.

As shown in Fig. 1, the conventional dual-side cooling power module 10 includes an upper substrate, a lower substrate, and a chip 17 disposed between the two substrates. The upper substrate includes a ceramic material layer 11 and metal layers 12 and 13 attached to both sides thereof, and the lower substrate includes a ceramic material layer 14 and metal layers 15 and 16 attached to both sides thereof. In order to electrically connect the chip 17 with the metal layer 13 and support the substrate, a spacer 18 is also disposed between the chip 17 and the metal layer 13. Similarly, in order to electrically connect the metal layer 13 with the metal layer 16 and support the substrate, a pillar 19 is also disposed between the metal layers 13 and 16 at the peripheral region of the power module. In addition, the chip 17 is also electrically connected to other electronic components (such as a gate resistor 21) through a wire 20.

The conventional power module 10 has many problems. First of all, both the spacer 18 and the pillar 19 are components independent of the metal layers and the chip and need to occupy a certain area and thickness, which makes it difficult to decrease the area and thickness of the power module. Further, the spacer 18 and the pillar 19 are not enough to achieve all the electric connections of the chip 17 and/or the metal layers 13 and 16, so that the chip 17 further needs to use the wire 20 to be connected to other electronic components. The process step of forming the wire includes the upper substrate be spaced apart from the lower substrate by a certain distance so that a corresponding tool can perform a wire bonding operation, which will further increase the thickness of the power module. Moreover, the wire 20 itself is prone to defects or failures, which leads to the overall performance degradation of the power module. Furthermore, the presence of the spacer 18 leads to a further increase of the heat dissipation path between the chip 17 and the metal layer 13 as well as an imbalance between the heat dissipation paths on both sides of the chip 17, which will reduce the heat dissipation efficiency of the chip 17. In addition, providing the spacer 18, the pillar 19 and the wire 20 in the power module at the same time lead to more steps and higher cost in the manufacturing process of the power module.

In view of the above problems, the inventor of the present application proposes new technical solutions of the dual-side cooling power module and manufacturing method thereof to overcome part or all of the above-mentioned shortcomings of the conventional power module.

Fig. 2 schematically shows a cross-sectional view of a dual-side cooling power module 100 according to an embodiment of the present disclosure. It is understood by those skilled in the art that although the power module 100 shown in Fig. 2 includes various components, this is only to present the various components as comprehensively as possible in the same set of drawings, and is not intended to constitute any limitation. The power module 100 according to an embodiment of the present disclosure can include only a part of various components shown in Fig. 2. In addition, the number, distribution, shape and size of respective components shown in Fig. 2 are only for illustration and are not intended to constitute any limitation. The power module 100 according to an embodiment of the present disclosure can include any number, any distribution, any shape and any size of the above-mentioned components.

As shown in Fig. 2, the dual-side cooling power module 100 according to an embodiment of the present disclosure can include a first multilayer structure or substrate, designated below as substrate, and a second multilayer structure or substrate, designated below as subtrate. The first multilayer substrate can include: a first insulating material layer 110; a first metal layer 120 disposed on one surface of the first insulating material layer 110 and attached to the first insulating material layer 110; and a second metal layer 130 disposed on the opposite other surface of the first insulating material layer 110 and attached to the first insulating material layer 110. The second metal layer 130 can include a plurality of first step structures 132 having a same first height. Similar to the first multilayer substrate, the second multilayer substrate can include: a second insulating material layer 140; a third metal layer 150 disposed on one surface of the second insulating material layer 140 and attached to the second insulating material layer 140; and a fourth metal layer 160 disposed on the opposite other surface of the second insulating material layer 140 and attached to the second insulating material layer 140. The fourth metal layer 160 can include a plurality of second step structures 162 having a same second height.

In some embodiments, the first insulating material layer 110 and the second insulating material layer 140 can be formed of a ceramic material or other suitable insulating materials. The first metal layer 120, the second metal layer 130, the third metal layer 150 and the fourth metal layer 160 can be formed of, for example, copper (Cu), aluminum (Al) or other suitable metal materials. In some embodiments, the first insulating material layer 110 can include a first ceramic substrate. In some embodiments, the first metal layer 120 and the second metal layer 130 can include copper layers attached onto top and bottom surfaces of the first insulating material layer 110, respectively, and can be attached to the first insulating material layer 110 by a process such as sintering, brazing, soldering, curing, or the like. In some embodiments, the second insulating material layer 140 can include a second ceramic substrate. In some embodiments, the third metal layer 150 and the fourth metal layer 160 can be copper layers attached onto top and bottom surfaces of the second insulating material layer 140, respectively, and can be attached to the second insulating material layer by a process such as sintering, brazing, soldering, curing, or the like. In some embodiments, the first multilayer substrate and/or second multilayer substrate can include one of the following: a Direct Bond Copper (DBC) substrate, an Active Metal Braze (AMB) substrate, and an Insulated Metal Substrate, respectively.

With continued reference to Fig. 2, the power module 100 further includes chips 170A and 170B. These chips are disposed between the first multilayer substrate and the second multilayer substrate and attached to the second metal layer 130 having the first step structure 132 and the fourth metal layer 160 having the second step structure 162. As shown in Fig. 2, each chip 170A, 170B can be attached and supported between a corresponding first step structure 132 and a corresponding second step structure 162, and electrically connected with the corresponding first step structure 132 and the corresponding second step structure 162.

In some embodiments, the chips 170A and 170B can be attached to the second metal layer 130 and the fourth metal layer 160 through a flip-chip process. In some embodiments, chips 170A and 170B can include power chips.

It is understood by those skilled in the art that although two chips 170A and 170B and their relative positions are shown in Fig. 2, this is not intended to constitute any limitation. The power module 100 according to an embodiment of the present disclosure can also include only one chip or more chips, and the relative position relationship of each chip can be arbitrarily set according to requirements.

In embodiments of the present disclosure, "attaching" means, for example, bonding each other by using an electrically and thermally conductive material, and can be performed by a process such as sintering, welding, or the like. For example, as shown in Fig. 2, the chips 170A and 170B can be attached to the corresponding first step structure 132 and the corresponding second step structure 162 by an electrically and thermally conductive attaching material layer 180. It should be noted that the plurality of attaching material layers 180 in Fig. 2 are intended to show the connection relationship among components attached to each other, and do not mean that these attaching material layers 180 all contain the same material. In other words, these attaching material layers 180 can contain the same or different attaching materials, and the attaching material can be any material known in the art for attaching.

In the power module according to an embodiment of the present disclosure, the chip is attached and supported between the first multilayer substrate and the second multilayer substrate by using step structures (e.g., the first step structure 132 and the second step structure 162) of both the upper and lower metal layers (e.g., the second metal layer 130 and the fourth metal layer 160), so that the electric connection of the chip is achieved without using any spacer, and at the same time, the heat generated by the chip can be evenly dissipated from both sides thereof. In the packaged power module 100, as shown in Fig. 2, the first metal layer 120 of the first multilayer substrate and the third metal layer 150 of the second multilayer substrate are at least partially exposed from top and bottom surfaces of a molded housing 102 of the power module, so as to dissipate the heat generated by the whole power module (especially the chips therein) during operation, thereby achieving the effect of dual-side cooling.

In some embodiments, the second metal layer 130 (especially the first step structure 132) can be shaped by a half-etching process step, and the fourth metal layer 160 (especially the second step structure 162) can also be shaped by a half-etching process step. Preferably, the first height of the first step structure 132 and the second height of the second step structure 162 can be the same. On the one hand, the same step height makes the chips 170A and 170B located at the approximately middle position in the thickness direction (the Z direction shown in Fig. 2) of the power module, so that the heat can be more evenly dissipated from both the upper and lower sides of the chips. On the other hand, the same step height enables the second metal layer 130 (especially its first step structure 132) and the fourth metal layer 160 (especially its second step structure 162) to be shaped by a same half-etching process, thus simplifying the manufacturing process and reducing the manufacturing cost.

In some embodiments, the chips disposed between the first multilayer substrate and the second multilayer substrate can be disposed in directions opposite to each other, that is, a part of the chips face toward the first multilayer substrate with their front surfaces and the other part of the chips face toward the first multilayer substrate with their back surfaces. It should be noted that the front and back surfaces of the chip are relative and interchangeable. For example, in the case that the chip is a power chip, the front surface of the chip refers to, for example, its surface disposed with a gate contact and a source contact, and the back surface of the chip refers to, for example, its surface disposed with a drain contact, or vice versa, that is, the front surface of the chip refers to its surface disposed with a drain contact and the back surface of the chip refers to its surface disposed with a gate contact and a source contact.

Taking Fig. 2 as an example, the chips in the power module 100 include: a first chip 170A attached to the second metal layer 130 with its front surface and attached to the fourth metal layer 160 with its back surface; and a second chip 170B attached to the fourth metal layer 160 with its front surface and attached to the second metal layer 130 with its back surface. In more detail, the first chip 170A is disposed with the front surface facing toward the first multilayer substrate, so that the gate contact 172 and the source contact 176 on the front surface thereof are attached to the first step structures 132 of the second metal layer 130, and the drain contact 174 on the back surface thereof is attached to the second step structure 162 of the fourth metal layer 160. The second chip 170B is disposed with its back surface facing toward the first multilayer substrate, so that the gate contact 172 and the source contact 176 on the front surface thereof are attached to the second step structures 162 of the fourth metal layer 160, and the drain contact 174 on the back surface thereof is attached to the first step structure 132 of the second metal layer 130. Certainly, because the front and back surfaces of the chip are relative and interchangeable, it can also be considered that the first chip 170A is disposed with its back surface facing toward the first multilayer substrate, while the second chip 170B is disposed with its front surface facing toward the first multilayer substrate.

It is understood by those skilled in the art that although Fig. 2 schematically shows the relative arrangement of gate contacts, source contacts and drain contacts of the chips 170A and 170B, this is not intended to constitute any limitation. The chip in the power module according to embodiments of the present disclosure can include any number, any distribution, any shape and any size of contacts. In addition, although Fig. 2 shows the source contact and the gate contact in the same cross-sectional view, in some embodiments, the source contact and the gate contact may not appear in the same cross-sectional view.

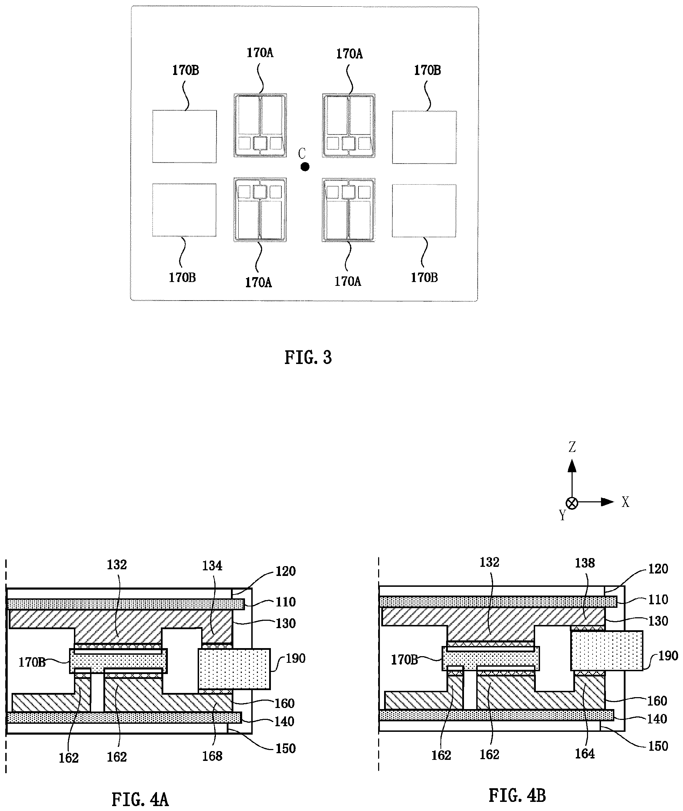

In some embodiments, the power module 100 can include a plurality of first chips 170A and a plurality of second chips 170B, and the number of the plurality of first chips 170A is the same as the number of the plurality of second chips 170B. The plurality of first chips 170A can be arranged in a centrally symmetric distribution in a plane parallel to the first multilayer substrate and the second multilayer substrate with respect to the center of the first multilayer substrate or the second multilayer substrate, and so can the plurality of second chips 170B. In order to illustrate this situation more clearly, Fig. 3 schematically shows a schematic diagram of chip distribution in the power module that includes more chips according to an embodiment of the present disclosure.

Compared with the distribution situation of two chips shown in Fig. 2, Fig. 3 schematically shows a possible distribution manner of these chips when more chips are disposed in the power module. As shown in Fig. 3, the power module can include a plurality of first chips 170A disposed with their front surfaces facing toward the first multilayer substrate and a plurality of second chips 170B disposed with their back surfaces facing toward the first multilayer substrate. The plurality of first chips 170A can be arranged in a centrally symmetric distribution in a plane parallel to the first multilayer substrate and the second multilayer substrate with respect to the center of the first multilayer substrate or the second multilayer substrate, and a plurality of second chips 170B can also be arranged in a centrally symmetric distribution in a plane parallel to the first multilayer substrate and the second multilayer substrate with respect to the center of the first multilayer substrate or the second multilayer substrate. Fig. 2 schematically shows the center C of the second multilayer substrate.

By arranging the plurality of chips in opposite directions, the performance of the power module according to an embodiment of the present disclosure can be significantly improved.

On one hand, gate lines are usually thinner than source lines and drain lines and need to be isolated from the source lines, so in a single metal layer of the multilayer substrate, the greater the distribution density of the gate lines, the greater the etching difficulty. If all chips in the power module are arranged in the same direction, all gate lines will be concentrated in a single metal layer of a single multilayer substrate (for example, one of the second metal layer 130 and the fourth metal layer 160), which will lead to an extremely difficult etching process for shaping the corresponding metal layer. In an embodiment according to the present disclosure, by arranging a plurality of chips of the power module in opposite directions, the gate lines can be respectively distributed in two metal layers (for example, both the second metal layer 130 and the fourth metal layer 160) of both the upper and lower multilayer substrates, thereby halving the distribution density of the gate lines in a single metal layer. This can significantly reduce the etching difficulty of the metal layer of the multilayer substrate and maximize the utilization rate of the metal layer, thereby improving the integration of the power module, simplifying its manufacturing process and reducing its manufacturing cost.

On the other hand, in a preferred embodiment, the number of the first chips with their front surfaces facing toward the first multilayer substrate and the number of the second chips with their back surfaces facing toward the first multilayer substrate in the power module are the same, and they are arranged in a centrally symmetric distribution in a plane parallel to the first multilayer substrate and the second multilayer substrate with respect to the center of the first multilayer substrate or the second multilayer substrate. This makes the corresponding metal layers (for example, the second metal layer 130 and the fourth metal layer 160) located above and below the chips also in an approximately symmetric pattern distribution. The symmetric pattern distribution makes the corresponding metal layers (for example, the second metal layer 130 and the fourth metal layer 160) have approximately the same warpage after manufacturing, thereby avoiding failure problems or performance deterioration caused by different warpages of the corresponding metal layers.

With continued reference to Fig. 2, the power module 100 according to an embodiment of the present disclosure can further include one or more leads (also called pins) 190 from a lead frame, and at least one of the second metal layer 130 and the fourth metal layer 160 can further include a step structure for attaching and supporting the lead 190. In some embodiments, the second metal layer 130 can include one or more third step structures 134 disposed at the periphery of the second metal layer and having a first height, and each third step structure 134 is used for attaching and supporting a corresponding lead 190; and/or, the fourth metal layer 160 can further include one or more fourth step structures 164 disposed at the periphery of the fourth metal layer and having a second height, and each fourth step structure 164 is used for attaching and supporting a corresponding lead 190.

For example, in some embodiments, the second metal layer 130 includes the third step structure 134, while the fourth metal layer 160 does not include any fourth step structure 164. In some other embodiments, the fourth metal layer 160 includes the fourth step structure 164, while the second metal layer 130 does not include any third step structure 134. In still some other embodiments, the second metal layer 130 includes the third step structure 134, and the fourth metal layer 160 includes the fourth step structure 164, just as shown in Fig. 2.

In some embodiments, at least one of the first step structures 132 attached to a chip is electrically connected to a corresponding third step structure 134 through a planar portion 136 of the second metal layer, thereby electrically connecting the chip to a corresponding lead 190; and/or, at least one of the second step structures 162 attached to a chip is electrically connected to a corresponding fourth step structure 164 through a planar portion 166 of the fourth metal layer, thereby electrically connecting the chip to a corresponding lead 190.

In some embodiments, the leads 190 can include at least one of: a first lead attached and supported between a corresponding third step structure and a corresponding fourth step structure; a second lead attached and supported between a corresponding third step structure and a planar edge portion of the fourth metal layer; and a third lead attached and supported between a planar edge portion of the second metal layer and a corresponding fourth step structure. In some embodiments, the lead 190 shown in Fig. 2 is a first lead attached and supported between a corresponding third step structure 134 and a corresponding fourth step structure 164. Figs. 4A and 4B schematically show cross-sectional views of a lead connection portion of the power module according to an embodiment of the present disclosure. The lead 190 shown in Fig. 4A is a second lead attached and supported between a corresponding third step structure 134 and a planar edge portion 168 of the fourth metal layer, while the lead 190 shown in Fig. 4B is a third lead attached and supported between a planar edge portion 138 of the second metal layer and a corresponding fourth step structure 164.

In some embodiments, at least one of following has an island-shaped blind end structure, which may be a stand alone or separate structure that is spaced from the closest or nearest structure by a space. The one or more third step structures 134, the one or more fourth step structures 164, the planar edge portion 138 of the second metal layer, and the planar edge portion 168 of the fourth metal layer. In embodiments of the present disclosure, the blind end structure may refer to an island-shaped end portion in the metal layer which is located at a periphery position of the metal layer and isolated from other structures of the metal layer. Because it is isolated from other structures in the metal layer, the blind end portion is only electrically connected to the lead attached to it. For example, as shown in Fig. 2, the leftmost fourth step structure 164 has an island-shaped blind end structure, which is only electrically connected to a corresponding lead 190 and isolated from other portions of the fourth metal layer. The blind end structure serves to support a pin 190 so that it can be more closely connected to the metal layer on the other side.

In some embodiments, the lead 190 can be not only used to achieve an electric connection extending to the outside of the housing 102 of the power module, but also used to achieve an electric connection only inside the power module without being led out. As shown in Fig. 2, the lead 190 on the left side is attached between a corresponding third step structure 134 and fourth step structure 164 so as to electrically connect both of them, but does not extend the electric connection to the outside of the power module. For this reason, the corresponding lead 190 can be cut short so as not to be exposed outside the housing 102 of the power module in the manufacturing process of the power module.

In an embodiment of the present disclosure, the lead 190 is supported and attached by using the third step structure and/or fourth step structure, so that the lead 190 can be steadily electrically connected to the second metal layer 130 and/or the fourth metal layer 160 without using other wires, thus achieving the electric connection with the chip. Further, the combination of the lead 190 and the corresponding third and fourth step structures can also form a steady mechanical support between the first and second multilayer substrates, thereby replacing the pillar in the conventional power module. In addition, supporting and attaching the lead 190 by using the third step structure and/or fourth step structure can also reduce the space for attaching the lead 190 and simplify the process flow for attaching the lead 190, thereby further reducing the thickness and manufacturing cost of the power module.

Compared with the conventional power module, the power module 100 according to an embodiment of the present disclosure achieves many improvements. First of all, in the present application, step structures are formed in the corresponding metal layers of the multilayer substrate, and the chips and leads are attached between the corresponding step structures. These step structures can not only provide a mechanical support but also achieve an electric connection, thereby replacing the spacers and pillars in the conventional power module and thus greatly reducing the area and thickness of the power module. Further, the chip is disposed at the middle position between the upper and lower substrates by the step structures, so that the heat dissipation paths on both sides of the chip are similar in length, thereby achieving a better heat dissipation effect. In addition, by disposing the chips in the power module in different directions and symmetric arrangement, the corresponding metal layers of both the upper and lower multilayer substrates can be more fully utilized to achieve the electric connection and avoid the use of wire connection in the packaged module, which further reduces the area and thickness of the power module. Moreover, the step structures and the metal layers where the step structures are located are integrally formed by a half-etching process, which simplifies the process steps of attaching various components, thereby simplifying the manufacturing flow of the power module and reducing the manufacturing cost.

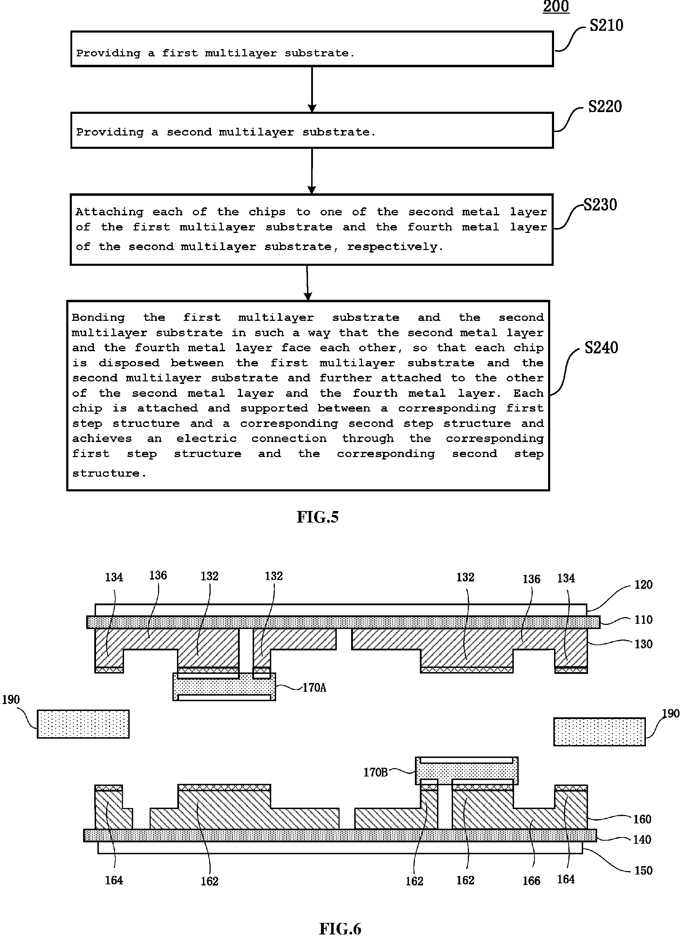

Next, a manufacturing method of a dual-side cooling power module according to an embodiment of the present disclosure will be described with reference to Figs. 5 and 6. Fig. 5 shows an exemplary flow diagram of a manufacturing method of a dual-side cooling power module according to an embodiment of the present disclosure. Fig. 6 schematically shows a cross-sectional view of an apparatus corresponding to a part of steps of the method shown in Fig. 5. It will be understood by those skilled in the art that the manufacturing method 200 of the dual-side cooling power module described in conjunction with Figs. 5 and 6 can be used to manufacture the power module 100 described in the previous embodiment of the present disclosure, so the corresponding description of the power module 100 is also applicable here.

As shown in Fig. 5, a manufacturing method 200 of a dual-side cooling power module according to an embodiment of the present disclosure can include steps S210, S220, S230 and S240.

At step S210, referring to Fig. 6, a first multilayer substrate is provided. The first multilayer substrate includes: a first insulating material layer 110; a first metal layer 120 on one surface of the first insulating material layer and attached to the first insulating material layer; and a second metal layer 130 on the opposite other surface of the first insulating material layer and attached to the first insulating material layer. The second metal layer 130 include a plurality of first step structures 132 having a first height.

At step S220, referring to Fig. 6, a second multilayer substrate is provided. The second multilayer substrate includes: a second insulating material layer 140; a third metal layer 150 on one surface of the second insulating material layer and attached to the second insulating material layer; and a fourth metal layer 160 on the opposite other surface of the second insulating material layer and attached to the second insulating material layer. The fourth metal layer 160 include a plurality of second step structures 162 having a second height.

At step S230, referring to Fig. 6, each of the chips 170A and 170B is attached to one of the second metal layer 130 of the first multilayer substrate and the fourth metal layer 160 of the second multilayer substrate, respectively.

In some embodiments, all chips can be attached to the second metal layer 130, or all chips can be attached to the fourth metal layer 160, or a part of chips can be attached to the second metal layer 130 and the other part of chips can be attached to the fourth metal layer 160.

At step S240, referring to Fig. 6, the first multilayer substrate and the second multilayer substrate are bonded in such a way that the second metal layer 130 and the fourth metal layer 160 face each other, so that each chip is disposed between the first multilayer substrate and the second multilayer substrate and further attached to the other of the second metal layer 130 and the fourth metal layer 160. Each chip is attached and supported between the corresponding first step structure 132 and the corresponding second step structure 162 and is electrically connected with them.

In some embodiments, the first height of the first step structures 132 and the height of the second step structures 162 are the same. In this case, the manufacturing method 200 can further include the step of: shaping the second metal layer 130 and the fourth metal layer 160 by a same half-etching process step to form a plurality of first step structures 132 and a plurality of second step structures 162, respectively.

In some embodiments, the chips include: a first chip 170A attached to the second metal layer 130 with its front surface and attached to the fourth metal layer 160 with its back surface; and a second chip 170B attached to the fourth metal layer 160 with its front surface and attached to the second metal layer 130 with its back surface. In this case, as shown in Fig. 6, step S230 of the manufacturing method 200 can include: attaching the first chip 170A to the second metal layer 130 of the first multilayer substrate with its front surface and attaching the second chip 170B to the fourth metal layer 160 of the second multilayer substrate with its front surface. Step S240 of the manufacturing method 200 can include: bonding the first multilayer substrate attached with the first chip 170A and the second multilayer substrate attached with the second chip 170B in such a way that the second metal layer 130 and the fourth metal layer 160 face each other, so that the first chip 170A is attached to the fourth metal layer 160 of the second multilayer substrate with its back surface and the second chip 170B is attached to the second metal layer 130 of the first multilayer substrate with its back surface.

In some embodiments, the power module includes a plurality of first chips 170A and a plurality of second chips 170B, and the number of the plurality of first chips 170A is the same as the number of the plurality of second chips 170B. The plurality of first chips 170A are arranged in a centrally symmetric distribution in a plane parallel to the first multilayer substrate and the second multilayer substrate with respect to the center of the first multilayer substrate or the second multilayer substrate, and the plurality of second chips 170B are also arranged in a centrally symmetric distribution in a plane parallel to the first multilayer substrate and the second multilayer substrate with respect to the center of the first multilayer substrate or the second multilayer substrate.

In some embodiments, the manufacturing method 200 can further include the step of: attaching one or more leads 190 from a lead frame to the second metal layer 130 and/or the fourth metal layer 160. The second metal layer 130 can further include one or more third step structures 134 disposed at the periphery of the second metal layer and having a first height, and each third step structure is used for attaching and supporting a corresponding lead 190. The fourth metal layer 160 can further includes one or more fourth step structures 164 disposed at the periphery of the fourth metal layer and having a second height, and each fourth step structure is used for attaching and supporting a corresponding lead 190. Fig. 6 schematically shows the position where the lead 190 is disposed before it is attached to the metal layer. In some embodiments, the lead 190 is first attached to one of the second metal layer 130 and the fourth metal layer 160, and then attached to the other of the second metal layer 130 and the fourth metal layer 160 in the aforementioned step 240. In some other embodiments, the lead 190 is attached to both the second metal layer 130 and the fourth metal layer 160 at the same time in the aforementioned step 240.

In some embodiments, the first step structure 132 and the third step structure 134 are shaped by a same half-etching process step. In some embodiments, the second step structure 162 and the fourth step structure 164 are shaped by a same half-etching process step.

In some embodiments, the leads 190 can include at least one of: a first lead attached and supported between a corresponding third step structure and a corresponding fourth step structure; a second lead attached and supported between a corresponding third step structure and a planar edge portion of the fourth metal layer; and a third lead attached and supported between a planar edge portion of the second metal layer and a corresponding fourth step structure.

In some embodiments, at least one of the following has an island-shaped blind end structure: the one or more third step structures, the one or more fourth step structures, the planar edge portion of the second metal layer, and the planar edge portion of the fourth metal layer.

In some embodiments, at least one of the first step structures 132 attached to a chip is electrically connected to a corresponding third step structure 134 through a planar portion 136 of the second metal layer, thereby electrically connecting the chip to a corresponding lead. In some embodiments, at least one of the second step structures 162 attached to a chip is electrically connected to a corresponding fourth step structure 164 through a planar portion 166 of the fourth metal layer, thereby electrically connecting the chip to a corresponding lead.

In some embodiments, the attaching includes bonding together by sintering or welding using an electrically and thermally conductive material. The one or more chips may include power chips. The one or more chips may be attached to the second metal layer and/or the fourth metal layer through a flip-chip process. The first insulating material layer may include a first ceramic substrate. The first metal layer and the second metal layer may include copper layers attached onto top and bottom surfaces of the first insulating material layer, respectively. The first metal layer and the second metal layer may be attached to the first insulating material layer by sintering, brazing, soldering, curing, or the like. The second insulating material layer may include a second ceramic substrate. The third metal layer and the fourth metal layer may include copper layers attached onto top and bottom surfaces of the second insulating material layer, respectively. The third metal layer and the fourth metal layer may be attached to the second insulating material layer by sintering, brazing, soldering, curing, or the like.

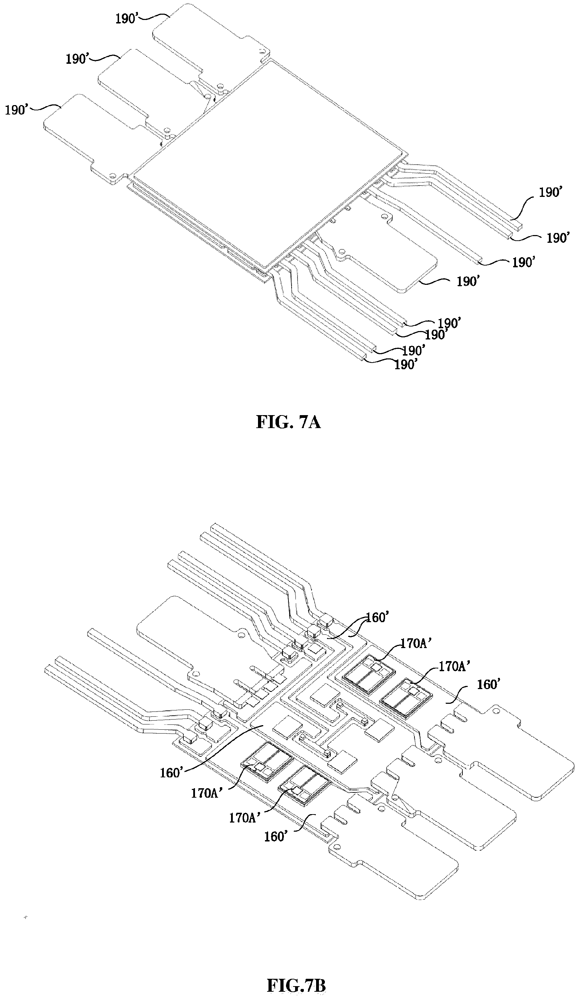

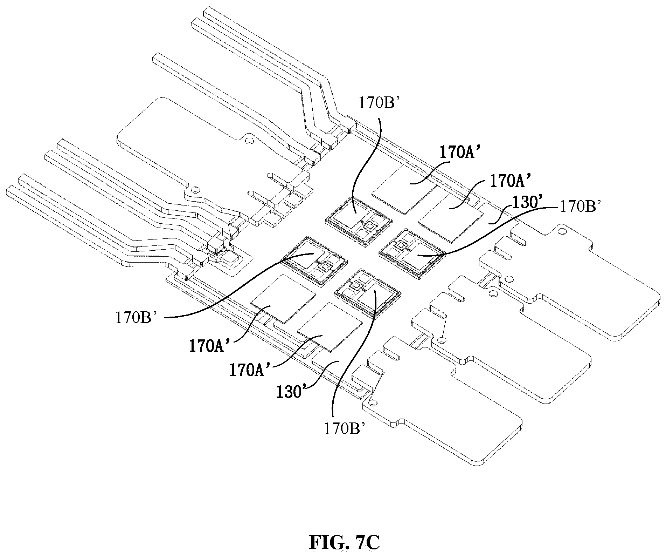

Fig. 7A shows a schematic three-dimensional modeling model of a dual-side cooling power module according to an embodiment of the present disclosure. Referring to Fig. 7A, the distribution of pins 190' of the dual-side cooling power module is shown. Fig. 7B shows a top perspective view of a part of components in the power module of Fig. 7A (viewed in a direction from the first multilayer substrate toward the second multilayer substrate). Referring to Fig. 7B, the distribution of the first chips 170A' and the fourth metal layer 160' is shown. Fig. 7C shows a bottom perspective view of a part of components in the power module of Fig. 7A (viewed in a direction from the second multilayer substrate toward the first multilayer substrate). Referring to Fig. 7C, the distribution of the second chips 170B' and the second metal layer 130' is shown.

It is understood by those skilled in the art that the above modeling model shown in Figs. 7A to 7C is only for the convenience of those skilled in the art to better understand the technical concept of the present disclosure, and is not intended to constitute any limitations.

The present application also proposes an electrical system, which can include a dual-side cooling power module according to any embodiment of the present disclosure. As an example, the electrical system can include, for example, an inverter, a new energy vehicle, a wind power system, a solar power generation system, an energy storage system, and any other devices or systems that need to use the power module of the present disclosure.

As used herein, the word "chip" includes, but is not limited to, a die.

Terms "front," "back," "top," "bottom," "above," "below," and the like in the description and the claims, if any, are used for descriptive purposes and not necessarily for describing permanent relative positions. It should be understood that the terms so used are interchangeable where appropriate such that the embodiments of the present disclosure described herein, for example, can operate in other orientations different from those illustrated herein or otherwise described.

As used herein, a term "exemplary" means "serving as an example, instance, or illustration," and not as a "model" that is to be reproduced exactly. Any implementation exemplarily described herein is not necessarily to be construed as preferred or advantageous over other implementations. Furthermore, the present disclosure is not limited by any expressed or implied theory presented in the above TECHNICAL FIELD, BACKGROUND, SUMMARY, or DETAILED DESCRIPTION.

As used herein, a term "substantially" or "about" means encompassing any minor variations caused by imperfections in design or manufacturing, tolerances of components or elements, environmental effects and/or other factors. The term "substantially" or "about" also allows for differences from a perfect or ideal situation caused by parasitic effect, noise, and other practical considerations that may exist in a practical implementation.

In addition, the foregoing description may mention elements or nodes or features that are "connected" or "coupled" together. As used herein, unless expressly stated otherwise, "connected" means that one element/node/feature is directly connected with (or directly communicates with) another element/node/feature in an electrical, mechanical, logical, or other manner. Similarly, unless expressly stated otherwise, "coupled" means that one element/node/feature may be directly or indirectly connected with another element/node/feature in a mechanical, electrical, logical or other manner, to allow interaction, even if the two elements are not directly connected. That is, "coupled" is intended to include direct and indirect connections of elements or other features, including connection using one or more intermediate elements.

In addition, for reference purposes only, similar terms such as "first" and "second" can also be used herein, and thus are not intended to be limiting. For example, unless clearly indicated by the context, the terms "first," "second" and other such numerical terms involving structures or elements do not imply a sequence or order.

It should be further understood that a term "comprise/include," when used herein, specifies the presence of stated features, wholes, steps, operations, units, and/or components, but does not preclude the presence or addition of one or more other features, wholes, steps, operations, units, components, and/or combinations thereof.

In the present disclosure, a term "provide" is used broadly to encompass all ways of obtaining an object, and thus "providing an object" includes, but is not limited to, "purchasing," "preparing / manufacturing," "arranging / setting," "installing / assembling," and/or "ordering" the object, and so on.

Those skilled in the art should realize that boundaries between the above operations are merely illustrative. Multiple operations can be combined into a single operation, a single operation can be distributed in additional operations, and the execution of the operations can be at least partially overlapped in time. Moreover, alternative embodiments can include multiple instances of specific operations, and the order of the operations may be altered in various other embodiments. However, other modifications, variations, and alternatives are also possible. Accordingly, this description and the accompanying drawings should be regarded as illustrative rather than restrictive.

Although some specific embodiments of the present disclosure have been described in detail through examples, it should be understood by those skilled in the art that the above examples are for illustration only and are not intended to limit the scope of the present disclosure. The embodiments disclosed herein can be combined arbitrarily without departing from the spirit and scope of the present disclosure. Those skilled in the art should also appreciate that various modifications can be made to the embodiments without departing from the scope and spirit of the present disclosure. The scope of the present disclosure is defined by the appended claims.

A dual-side cooling power module, is summarized as including: a first multilayer substrate, including: a first insulating material layer, a first metal layer on one surface of the first insulating material layer and attached to the first insulating material layer, and a second metal layer on the opposite other surface of the first insulating material layer and attached to the first insulating material layer, the second metal layer including a plurality of first step structures having a first height; a second multilayer substrate, including: a second insulating material layer, a third metal layer on one surface of the second insulating material layer and attached to the second insulating material layer, and a fourth metal layer on the opposite other surface of the second insulating material layer and attached to the second insulating material layer, the fourth metal layer including a plurality of second step structures having a second height; and one or more chips disposed between the first multilayer substrate and the second multilayer substrate and attached to the second metal layer and the fourth metal layer, wherein each chip is attached and supported between a corresponding first step structure and a corresponding second step structure and is electrically coupled with them, and wherein the first height is the same as the second height.

The first height is the same as the second height, and the second metal layer and the fourth metal layer are shaped by a same half-etching process step.

The one or more chips include: a first chip attached to the second metal layer with its front surface and attached to the fourth metal layer with its back surface; and a second chip attached to the fourth metal layer with its front surface and attached to the second metal layer with its back surface.

The one or more chips includes a plurality of first chips and a plurality of second chips, wherein the number of the plurality of first chips is the same as the number of the plurality of second chips; the plurality of first chips are arranged in a centrally symmetric distribution in a plane parallel to the first multilayer substrate and the second multilayer substrate with respect to a center of the first multilayer substrate or the second multilayer substrate; and the plurality of second chips are arranged in a centrally symmetric distribution in a plane parallel to the first multilayer substrate and the second multilayer substrate with respect to the center of the first multilayer substrate or the second multilayer substrate.

The dual-side cooling power module further includes: one or more leads from a lead frame; wherein the second metal layer further includes one or more third step structures disposed at periphery of the second metal layer and having the first height, the one or more third step structures configured to attach and support a corresponding lead; and/or wherein the fourth metal layer further includes one or more fourth step structures disposed at periphery of the fourth metal layer and having the second height, the one or more fourth step structures configured to attach and support a corresponding lead.

The one or more leads include at least one of: a first lead attached and supported between a corresponding third step structure and a corresponding fourth step structure; a second lead attached and supported between a corresponding third step structure and a planar edge portion of the fourth metal layer; and a third lead attached and supported between a planar edge portion of the second metal layer and a corresponding fourth step structure.

At least one of the one or more third step structures, the one or more fourth step structures, the planar edge portion of the second metal layer, and the planar edge portion of the fourth metal layer has an island-shaped blind end structure.

At least one of the plurality of first step structures attached to a chip is electrically coupled to a corresponding third step structure through a planar portion of the second metal layer, and electrically configured to couple the chip to a corresponding lead; and/or at least one of the plurality of second step structures attached to a chip is electrically coupled to a corresponding fourth step structure through a planar portion of the fourth metal layer, and electrically configured to couple the chip to a corresponding lead.

The attaching includes bonding together by sintering or welding using an electrically and thermally conductive material; the one or more chips include power chips; the one or more chips are attached to at least one of the second metal layer and the fourth metal layer through a flip-chip process; the first insulating material layer includes a first ceramic substrate; the first metal layer and the second metal layer are copper layers attached onto top and bottom surfaces of the first insulating material layer, respectively; the first metal layer and the second metal layer are attached to the first insulating material layer by sintering, brazing, soldering or curing; the second insulating material layer includes a second ceramic substrate; the third metal layer and the fourth metal layer are copper layers attached onto top and bottom surfaces of the second insulating material layer, respectively; and/or the third metal layer and the fourth metal layer are attached to the second insulating material layer by sintering, brazing, soldering or curing.

An electrical system, is summarized as including the dual-side cooling power module, including: a first multilayer substrate, including a first insulating material layer, a first metal layer on one surface of the first insulating material layer and attached to the first insulating material layer, and a second metal layer on the opposite other surface of the first insulating material layer and attached to the first insulating material layer. The second metal layer includes a plurality of first step structures having a first height.

A second multilayer substrate includes a second insulating material layer, a third metal layer on one surface of the second insulating material layer and attached to the second insulating material layer, and a fourth metal layer on the opposite other surface of the second insulating material layer and attached to the second insulating material layer. The fourth metal layer includes a plurality of second step structures having a second height.

One or more chips are disposed between the first multilayer substrate and the second multilayer substrate and attached to the second metal layer and the fourth metal layer, wherein each chip is attached and supported between a corresponding first step structure and a corresponding second step structure and is electrically coupled with them, wherein the first height is the same as the second height, and wherein the one or more chips include a first chip attached to the second metal layer with its front surface and attached to the fourth metal layer with its back surface, and a second chip attached to the fourth metal layer with its front surface and attached to the second metal layer with its back surface.

The electrical system includes one or more leads from a lead frame, wherein the second metal layer further includes one or more third step structures disposed at periphery of the second metal layer and having the first height, the one or more third step structures configured to attach and support a corresponding lead, and/or wherein the fourth metal layer further includes one or more fourth step structures disposed at periphery of the fourth metal layer and having the second height, the one or more fourth step structures configured to attach and support a corresponding lead.

A manufacturing method of a dual-side cooling power module, is summarized as including steps of: providing a first multilayer substrate, the first multilayer substrate including: a first insulating material layer, a first metal layer on one surface of the first insulating material layer and attached to the first insulating material layer, and a second metal layer on the opposite other surface of the first insulating material layer and attached to the first insulating material layer, the second metal layer including a plurality of first step structures having a first height; providing a second multilayer substrate, the second multilayer substrate including: a second insulating material layer, a third metal layer on one surface of the second insulating material layer and attached to the second insulating material layer, and a fourth metal layer on the opposite other surface of the second insulating material layer and attached to the second insulating material layer, the fourth metal layer including a plurality of second step structures having a second height; attaching each of one or more chips to one of the second metal layer of the first multilayer substrate and the fourth metal layer of the second multilayer substrate, respectively; and bonding the first multilayer substrate and the second multilayer substrate in such a way that the second metal layer and the fourth metal layer face each other, so that each chip is disposed between the first multilayer substrate and the second multilayer substrate and further attached to the other of the second metal layer and the fourth metal layer, wherein each chip is attached and supported between a corresponding first step structure and a corresponding second step structure and is electrically coupled with them, and wherein the first height is the same as the second height.

The first height is the same as the second height, and the manufacturing method further includes the step of: shaping the second metal layer and the fourth metal layer by a same half-etching process step so as to form the plurality of first step structures and the plurality of second step structures respectively.

The one or more chips include: a first chip attached to the second metal layer with its front surface and attached to the fourth metal layer with its back surface; and a second chip attached to the fourth metal layer with its front surface and attached to the second metal layer with its back surface.

The step of attaching each of one or more chips to one of the second metal layer of the first multilayer substrate and the fourth metal layer of the second multilayer substrate respectively includes: attaching a first chip to the second metal layer of the first multilayer substrate with its front surface, and attaching a second chip to the fourth metal layer of the second multilayer substrate with its front surface; and the step of bonding the first multilayer substrate and the second multilayer substrate in such a way that the second metal layer and the fourth metal layer face each other includes: bonding the first multilayer substrate attached with the first chip and the second multilayer substrate attached with the second chip in a manner that allows them to face each other such that the second metal layer and the fourth metal layer face each other, ensuring that the first chip is attached to the fourth metal layer of the second multilayer substrate with its back surface and the second chip is attached to the second metal layer of the first multilayer substrate with its back surface.

The one or more chips includes a plurality of first chips and a plurality of second chips, wherein the number of the plurality of first chips is the same as the number of the plurality of second chips; the plurality of first chips are arranged in a centrally symmetric distribution in a plane parallel to the first multilayer substrate and the second multilayer substrate with respect to a center of the first multilayer substrate or the second multilayer substrate; and the plurality of second chips are arranged in a centrally symmetric distribution in a plane parallel to the first multilayer substrate and the second multilayer substrate with respect to the center of the first multilayer substrate or the second multilayer substrate.

The manufacturing method further includes steps of: attaching one or more leads from a lead frame to at least one of the second metal layer and the fourth metal layer; wherein the second metal layer further includes one or more third step structures disposed at periphery of the second metal layer and having the first height, the one or more third step structures configured to attach and support a corresponding lead; and/or wherein the fourth metal layer further includes one or more fourth step structures disposed at periphery of the fourth metal layer and having the second height, the one or more fourth step structures configured to attach and support a corresponding lead.

The plurality of first step structures and the one or more third step structures are shaped by a same half-etching process step; and/or the plurality of second step structures and the one or more fourth step structures are shaped by a same half-etching process step.

The one or more leads include at least one of: a first lead attached and supported between a corresponding third step structure and a corresponding fourth step structure; a second lead attached and supported between a corresponding third step structure and a planar edge portion of the fourth metal layer; and a third lead attached and supported between a planar edge portion of the second metal layer and a corresponding fourth step structure.

At least one of the one or more third step structures, the one or more fourth step structures, the planar edge portion of the second metal layer, and the planar edge portion of the fourth metal layer has an island-shaped blind end structure.

At least one of the plurality of first step structures attached to a chip is electrically coupled to a corresponding third step structure through a planar portion of the second metal layer, and electrically configured to couple the chip to a corresponding lead; and/or at least one of the plurality of second step structures attached to a chip is electrically coupled to a corresponding fourth step structure through a planar portion of the fourth metal layer, and electrically configured to couple the chip to a corresponding lead.

The attaching includes bonding together by sintering or welding using an electrically and thermally conductive material; the one or more chips include power chips; the one or more chips are attached to at least one of the second metal layer and the fourth metal layer through a flip-chip process; the first insulating material layer includes a first ceramic substrate; the first metal layer and the second metal layer are copper layers attached onto top and bottom surfaces of the first insulating material layer, respectively; the first metal layer and the second metal layer are attached to the first insulating material layer by sintering, brazing, soldering or curing; the second insulating material layer includes a second ceramic substrate; the third metal layer and the fourth metal layer are copper layers attached onto top and bottom surfaces of the second insulating material layer, respectively; and/or the third metal layer and the fourth metal layer are attached to the second insulating material layer by sintering, brazing, soldering or curing.

The present disclosure can also correspond to the following examples.

Example 1. A dual-side cooling power module, comprising:
a first multilayer substrate, comprising:
   a first insulating material layer,
   a first metal layer on one surface of the first insulating material layer and coupled to the first insulating material layer, and
   a second metal layer on the opposite other surface of the first insulating material layer and coupled to the first insulating material layer, the second metal layer comprising a plurality of first step structures having a first height;
a second multilayer substrate, comprising:
   a second insulating material layer,
   a third metal layer on one surface of the second insulating material layer and coupled to the second insulating material layer, and
   a fourth metal layer on the opposite other surface of the second insulating material layer and coupled to the second insulating material layer, the fourth metal layer comprising a plurality of second step structures having a second height; and
one or more chips disposed between the first multilayer substrate and the second multilayer substrate and coupled to the second metal layer and the fourth metal layer,
wherein each chip is coupled and supported between a corresponding first step structure and a corresponding second step structure and is electrically coupled with them, and wherein the first height is the same as the second height.

Example 2. The dual-side cooling power module according to example 1, wherein the second metal layer and the fourth metal layer are shaped by a same half-etching process.

Example 3. The dual-side cooling power module according to example 1 or 2, wherein the one or more chips comprise:
a first chip coupled to the second metal layer with a front surface and coupled to the fourth metal layer with a back surface; and
a second chip coupled to the fourth metal layer with a front surface and coupled to the second metal layer with a back surface.

Example 4. The dual-side cooling power module according to claim 3, wherein:
the one or more chips comprises a plurality of first chips and a plurality of second chips, wherein the number of the plurality of first chips is the same as the number of the plurality of second chips;
the plurality of first chips are in a centrally symmetric distribution in a plane parallel to the first multilayer substrate and the second multilayer substrate with respect to a center of the first multilayer substrate or the second multilayer substrate; and
the plurality of second chips are in a centrally symmetric distribution in a plane parallel to the first multilayer substrate and the second multilayer substrate with respect to the center of the first multilayer substrate or the second multilayer substrate.

Example 5. The dual-side cooling power module according to any of examples 1 to 4, further comprising:
one or more leads from a lead frame;
wherein the second metal layer further comprises one or more third step structures at periphery of the second metal layer and having the first height, the one or more third step structures configured to attach and support a corresponding lead; and
wherein the fourth metal layer further comprises one or more fourth step structures at periphery of the fourth metal layer and having the second height, the one or more fourth step structures configured to couple and support a corresponding lead.

Example 6. The dual-side cooling power module according to example 5, wherein the one or more leads comprise at least one of:
a first lead coupled and supported between a corresponding third step structure and a corresponding fourth step structure;
a second lead coupled and supported between a corresponding third step structure and a planar edge portion of the fourth metal layer; and
a third lead coupled and supported between a planar edge portion of the second metal layer and a corresponding fourth step structure.

Example 7. The dual-side cooling power module according to example 6, wherein at least one of the one or more third step structures, the one or more fourth step structures, the planar edge portion of the second metal layer, and the planar edge portion of the fourth metal layer has an island-shaped blind end structure.

Example 8. The dual-side cooling power module according to example 5, wherein:
at least one of the plurality of first step structures coupled to a chip is electrically coupled to a corresponding third step structure through a planar portion of the second metal layer, and electrically configured to couple the chip to a corresponding lead; and
at least one of the plurality of second step structures coupled to a chip is electrically coupled to a corresponding fourth step structure through a planar portion of the fourth metal layer, and electrically configured to couple the chip to a corresponding lead.

Example 9. An electrical system, comprising:
a dual-side cooling power module, including:
   a first multilayer substrate, including:
      a first insulating material layer;
      a first metal layer on the first insulating material layer; and
      a second metal layer on the first insulating material layer and spaced from the first metal layer by the first insulating material layer, the second metal layer having a plurality of first step structures having a first height;
   a second multilayer substrate, including:
      a second insulating material layer;
      a third metal layer on the second insulating material layer; and
      a fourth metal layer on the second insulating material layer and spaced from the third metal layer by the second insulating material layer, the fourth metal layer having a plurality of second step structures having a second height;
a first plurality of chips coupled to the first multilayer substrate and facing the second multilayer substrate, the first plurality of chips being coupled to the second metal layer;
a second plurality of chips coupled to the second multilayer substrate and facing the first multilayer substrate, the second plurality of chips being coupled to the fourth metal layer, each chip of the first plurality of chips and the second plurality of chips is coupled and supported between a corresponding first step structure of the plurality of first step structures and a corresponding second step structure of the plurality of second step structures.

Example 10. The electrical system of example 9 wherein the first height is the same as the second height.

Example 11. A method, comprising:
forming a dual-side cooling power module, by:
   coupling each of one or more chips to a first multilayer structure and a second multilayer structure, the first multilayer structure includes a first insulating material layer, a first metal layer on the first insulating material layer, and a second metal layer on the first insulating material layer, the second metal layer comprising a plurality of first step structures having a first height, the second multilayer structure includes a second insulating material layer, a third metal layer on the second insulating material layer, and a fourth metal layer on the second insulating material layer, the fourth metal layer comprising a plurality of second step structures having a second height, the coupling including coupling each chip to one of the second metal layer of the first multilayer substrate and the fourth metal layer of the second multilayer substrate, respectively; and
   coupling the first multilayer substrate and the second multilayer substrate to have the second metal layer and the fourth metal layer face each other, wherein each chip is disposed between the first multilayer substrate and the second multilayer substrate and further coupled to the other of the second metal layer and the fourth metal layer,
wherein each chip is coupled and supported between a corresponding first step structure and a corresponding second step structure and is electrically coupled with them, and wherein the first height is the same as the second height.

Example 12. The method according to example 11, further comprising forming the plurality of first step structures and the plurality of second step structures respectively by shaping the second metal layer and the fourth metal layer by a same half-etching process.

Example 13. The method according to example 11 or 12, wherein the one or more chips comprise:
a first chip coupled to the second metal layer with a front surface and coupled to the fourth metal layer with a back surface; and
a second chip coupled to the fourth metal layer with a front surface and coupled to the second metal layer with a back surface.

Example 14. The method according to any of examples 11 to 13,
wherein the coupling each of one or more chips to one of the second metal layer of the first multilayer substrate and the fourth metal layer of the second multilayer substrate respectively comprises: attaching a first chip to the second metal layer of the first multilayer substrate with a front surface, and attaching a second chip to the fourth metal layer of the second multilayer substrate with a front surface; and
wherein the coupling the first multilayer substrate and the second multilayer substrate in such a way that the second metal layer and the fourth metal layer face each other comprises: bonding the first multilayer substrate coupled with the first chip and the second multilayer substrate coupled with the second chip in a manner that configures them to face each other such that the second metal layer and the fourth metal layer face each other, configuring that the first chip is coupled to the fourth metal layer of the second multilayer substrate with a back surface and the second chip is coupled to the second metal layer of the first multilayer substrate with a back surface.

Example 15. The method according to claim 13, wherein:
the one or more chips comprises a plurality of first chips and a plurality of second chips, wherein the number of the plurality of first chips is the same as the number of the plurality of second chips;
the plurality of first chips are arranged in a centrally symmetric distribution in a plane parallel to the first multilayer substrate and the second multilayer substrate with respect to a center of the first multilayer substrate or the second multilayer substrate; and
the plurality of second chips are arranged in a centrally symmetric distribution in the plane parallel to the first multilayer substrate and the second multilayer substrate with respect to the center of the first multilayer substrate or the second multilayer substrate.

Example 16. The method according to example 13, further comprising of:
attaching one or more leads from a lead frame to at least one of the second metal layer and the fourth metal layer;
wherein the second metal layer further comprises one or more third step structures disposed at periphery of the second metal layer and having the first height, the one or more third step structures configured to attach and support a corresponding lead; and/or
wherein the fourth metal layer further comprises one or more fourth step structures disposed at periphery of the fourth metal layer and having the second height, the one or more fourth step structures configured to attach and support a corresponding lead.

Example 17. The method according to example 16, wherein:
the plurality of first step structures and the one or more third step structures are shaped by a same half-etching process; and/or
the plurality of second step structures and the one or more fourth step structures are shaped by a same half-etching process.

Example 18. The method according to example 16, wherein the one or more leads comprise at least one of:
a first lead coupled and supported between a corresponding third step structure and a corresponding fourth step structure;
a second lead coupled and supported between a corresponding third step structure and a planar edge portion of the fourth metal layer; and
a third lead coupled and supported between a planar edge portion of the second metal layer and a corresponding fourth step structure.

Example 19. The method according to example 18, wherein at least one of the one or more third step structures, the one or more fourth step structures, the planar edge portion of the second metal layer, and the planar edge portion of the fourth metal layer has an island-shaped blind end structure.

Example 20. The method according to any of examples 11 to 19, wherein:
at least one of the plurality of first step structures coupled to a chip is electrically coupled to a corresponding third step structure through a planar portion of the second metal layer, and electrically configured to couple the chip to a corresponding lead; and/or
at least one of the plurality of second step structures coupled to a chip is electrically coupled to a corresponding fourth step structure through a planar portion of the fourth metal layer, and electrically configured to couple the chip to a corresponding lead.

The various embodiments described above can be combined to provide further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A dual-side cooling power module, comprising:
a first multilayer structure, comprising:
a first insulating material layer,
a first metal layer on one surface of the first insulating material layer, and
a second metal layer on the first insulating material layer, the second metal layer comprising a plurality of first step structures having a first height;
a second multilayer structure, comprising:
a second insulating material layer,
a third metal layer on the second insulating material layer, and
a fourth metal layer on the second insulating material layer, the fourth metal layer comprising a plurality of second step structures having a second height; and
one or more chips,
wherein each chip is coupled and supported between a corresponding first step structure and a corresponding second step structure.

2. The module of claim 1, wherein:
said first metal layer is coupled to the first insulating material layer;
said second metal layer is on the opposite other surface of the first insulating material layer and coupled to the first insulating material layer;
said third metal layer is on one surface of the second insulating material layer and coupled to the second insulating material layer;
said fourth metal layer is on the opposite other surface of the second insulating material layer and coupled to the second insulating material layer.

3. A method, comprising:
forming a dual-side cooling power module, by:
coupling each of one or more chips to a first multilayer structure and a second multilayer structure, the first multilayer structure includes a first insulating material layer, a first metal layer on the first insulating material layer, and a second metal layer on the first insulating material layer, the second metal layer comprising a plurality of first step structures having a first height, the second multilayer structure includes a second insulating material layer, a third metal layer on the second insulating material layer, and a fourth metal layer on the second insulating material layer, the fourth metal layer comprising a plurality of second step structures having a second height, the coupling including coupling each chip to one of the second metal layer of the first multilayer structure and the fourth metal layer of the second multilayer structure, respectively; and
coupling the first multilayer structure and the second multilayer structure to have the second metal layer and the fourth metal layer face each other,
wherein each chip is coupled and supported between a corresponding first step structure and a corresponding second step structure.

4. The module of claim 1 or 2, or the method of claim 3:
wherein each chip is disposed between the first multilayer structure and the second multilayer structure and further coupled to the other of the second metal layer and the fourth metal layer.

5. The module according to any of claims 1, 2, 4, or the method according to claim 3 or 4, wherein the one or more chips comprise:
a first chip coupled to the second metal layer with a front surface and coupled to the fourth metal layer with a back surface; and
a second chip coupled to the fourth metal layer with a front surface and coupled to the second metal layer with a back surface.

6. The module or the method according to claim 5, wherein:
the one or more chips comprises a plurality of first chips and a plurality of second chips, wherein the number of the plurality of first chips is the same as the number of the plurality of second chips;
the plurality of first chips are in a centrally symmetric distribution in a plane parallel to the first multilayer structure and the second multilayer structure with respect to a center of the first multilayer structure or the second multilayer structure; and
the plurality of second chips are in a centrally symmetric distribution in a plane parallel to the first multilayer structure and the second multilayer structure with respect to the center of the first multilayer structure or the second multilayer structure.

7. An electrical system, comprising a dual-side cooling power module according to claim 1.

8. The system of claim 7, wherein:
said second metal layer is spaced from the first metal layer by the first insulating material layer; and
said fourth metal layer is spaced from the third metal layer by the second insulating material layer;
a first plurality of chips of said one or more chips is coupled to the first multilayer structure and is facing the second multilayer structure, the first plurality of chips being coupled to the second metal layer;
a second plurality of chips of said one or more chips is coupled to the second multilayer structure and is facing the first multilayer structure, the second plurality of chips being coupled to the fourth metal layer, each chip of the first plurality of chips and the second plurality of chips being coupled and supported between a corresponding first step structure of the plurality of first step structures and a corresponding second step structure of the plurality of second step structures.

9. The module of any of claims 1, 2, 4 to 6, or the method of any of claims 3 to 6, or the system of claim 7 or 8, wherein each chip is electrically coupled with a corresponding first step structure and a corresponding second step structure

10. The module according to any of claims 1, 2, 4 to 6, 9, or the method of any of claims 3 to 6, 9, or the system of any of claims 7 to 9, wherein the second metal layer and the fourth metal layer are shaped by a same half-etching process.

11. The module according to any of claims 1, 2, 4 to 6, 9, 10, or the method of any of claims 3 to 6, 9, 10, or the system of any of claims 7 to 10, further comprising:
one or more leads from a lead frame;
wherein the second metal layer further comprises one or more third step structures at periphery of the second metal layer and having the first height, the one or more third step structures configured to attach and support a corresponding lead; and
wherein the fourth metal layer further comprises one or more fourth step structures at periphery of the fourth metal layer and having the second height, the one or more fourth step structures configured to couple and support a corresponding lead.

12. The module or method or system according to claim 11, wherein the one or more leads comprise at least one of:
a first lead coupled and supported between a corresponding third step structure and a corresponding fourth step structure;
a second lead coupled and supported between a corresponding third step structure and a planar edge portion of the fourth metal layer; and
a third lead coupled and supported between a planar edge portion of the second metal layer and a corresponding fourth step structure.

13. The module or method or system according to claim 12, wherein at least one of the one or more third step structures, the one or more fourth step structures, the planar edge portion of the second metal layer, and the planar edge portion of the fourth metal layer has an island-shaped blind end structure.

14. The module or method or system according to claim 11, wherein:
at least one of the plurality of first step structures coupled to a chip is electrically coupled to a corresponding third step structure through a planar portion of the second metal layer, and electrically configured to couple the chip to a corresponding lead; and
at least one of the plurality of second step structures coupled to a chip is electrically coupled to a corresponding fourth step structure through a planar portion of the fourth metal layer, and electrically configured to couple the chip to a corresponding lead.

15. The module of any of claims 1, 2, 4 to 6, 9 to 14, or the method of any of claims 3 to 6, 9 to 14, or the system of any of claims 7 to 14, wherein the first height is the same as the second height.

16. The module of any of claims 1, 2, 4 to 6, 9 to 15, or the method of any of claims 3 to 6, 9 to 15, or the system of any of claims 7 to 15, wherein the first multilayer structure is a first multilayer substrate and the second multilayer structure is a second multilayer substrate.
